# EUROPÄISCHE PATENTSCHRIFT

(11) **EP 0 794 461 B1**
(45) Veröffentlichungstag und Bekanntmachung des Hinweises auf die Patenterteilung: **20.10.1999**
(21) Anmeldenummer: 96810135.2
(22) Anmeldetag: 06.03.1996
(51) Int. Cl.: G03F 7/12, G03F 7/16

(54) **Rakelelement für eine Einrichtung zum Beschichten von Drucksieben**
Squeegee for a printing screen coating device
Raclette pour appareil d'enduction d'écrans de sérigraphie

(43) Veröffentlichungstag der Anmeldung: 10.09.1997
(73) Patentinhaber: Grünig-Interscreen AG, 3150 Schwarzenburg (CH)
(72) Erfinder: Grünig, Hans-Ulrich, CH-3150 Schwarzenburg (CH)
(74) Vertreter: BOVARD AG - Patentanwälte

(56) Entgegenhaltungen:
- EP-A- 0 608 661
- DE-C- 3 932 955
- US-A- 4 078 486

## Beschreibung

Die vorliegende Erfindung bezieht sich auf ein Rakelelement für eine Einrichtung zum Beschichten von Drucksieben gemäss dem Oberbegriff des Patentanspruchs 1.

Rakelelemente für derartige Einrichtungen sind bekannt. So zeigt beispielsweise die EP-A-0 608 661 derartige Rakelelemente für eine Einrichtung zum Beschichten von Drucksieben. Diese Rakelelemente bestehen im wesentlichen aus einem Profil, das eine Wanne bildet, welche jeweils stirnseitig durch eine Seitenwand verschlossen ist. Dieses Profil ist jeweils in einen Wagen einhängbar, welcher entlang des Drucksiebes verfahrbar ist, wobei bei angestelltem und hochgeschwenktem Rakelelement eine Beschichtung erfolgt.

Bei diesen Rakelelementen dient die Vorderkante des Profils gleichzeitig als Rakelkante. Da die aufzutragenden Schichtdicken immer kleiner werden, wachsen die Anforderungen an die Rakelkante des Rakelelementes, indem der Krümmungsradius dieser Rakelkante entsprechend der dünneren aufzutragenden Schicht ebenfalls kleiner ausgebildet sein muss. Dadurch wird die Belastung und demzufolge die Abnützung der Rakelkante ansteigen, die Anforderungen an die Genauigkeit der Ausbildung der Rakelkante nehmen entsprechend zu.

Diese Rakelelemente werden vorzugsweise aus einem Profil gebildet, das aus Leichtmetall gezogen ist. Durch das Ziehen kann die erforderliche Genauigkeit der Rakelkante erreicht werden. Die Verschleissfestigkeit der Rakelkante ist aber nicht optimal, da oft nicht das für die Verwendung geeignetste Material angewendet werden kann. Insbesondere ist es in den meisten Fällen nicht möglich, die Verschleissfestigkeit der Rakelkante durch entsprechende Materialbehandlung zu verbessern. Dadurch ergibt sich somit eine relativ rasche Abnützung der Rakelkante, wodurch die Qualität der Beschichtung abnimmt. Die Rakelkante kann nicht oder nur mit grossem Aufwand nachbearbeitet werden, da diese Nachbearbeitung in Längsrichtung der Rakelkante erfolgen müsste. Bei einer Querbearbeitung könnten in der Rakelkante quer zu dieser verlaufende Riefen entstehen, welche sich auf die Beschichtungsqualität negativ auswirken könnten. Man ist somit gezwungen, die relativ rasch abgenützten Rakelelemente durch neue zu ersetzen, wobei die gebrauchten als Verschleissmaterial anfallen.

Die Aufgabe der Erfindung besteht nun darin, derartige Rakelelemente so zu gestalten, dass die Verschleissfestigkeit verbessert wird und mindestens die die Wanne bildenden Profile der Rakelelemente mehrfach wiederverwendbar sind.

Erfindungsgemäss erfolgt die Lösung dieser Aufgabe durch die in der Kennzeichnung des Anspruchs 1 angegebenen Merkmale.

Durch die Möglichkeit eines Austauschens eines Kantenelements auf dem Rakelelement kann im Bereich der Rakelkante das für die jeweilige Beschichtung geeignetste Material verwendet werden. Durch den damit verbundenen geringeren Verschleiss wird eine Verbesserung der Beschichtung erreicht.

In vorteilhafter Weise ist das Kantenelement aus einem Flachprofil gebildet, bei welchem die beiden Schmalseiten als Rakelkanten ausgebildet sind, wodurch nach der Abnützung der einen Rakelkante das Flachprofil auf dem Rakelelement umgekehrt werden kann, so dass die andere Rakelkante zum Einsatz kommt.

Eine weitere vorteilhafte Ausgestaltung der Erfindung besteht darin, dass die Haltemittel aus einem am Rakelelement längs verlaufenden Schwalbenschwanzprofil und aus einer eine entsprechende Form aufweisende, in das Kantenelement eingearbeitete Nut bestehen, wodurch das Kantenelement auf das Rakelelement in einfacher Weise von der Seite her aufgeschoben werden kann.

Weitere vorteilhafte Ausgestaltungen der Erfindung ergeben sich aus den weiteren abhängigen Ansprüchen.

Eine Ausführungsform der Erfindung wird nachfolgend anhand der beiliegenden Zeichnung beispielhaft näher erläutert.

Es zeigt
Fig. 1 in schematischer Darstellung eine Einrichtung zum Beschichten von Drucksieben mit den darin angeordneten Rakelelementen;
Fig. 2 eine Schnittdarstellung einer Halterung eines Rakelelementes; und
Fig. 3 eine Schnittdarstellung des Bereichs der Rakelvorderkante des Rakelelementes mit aufgesetztem Kantenelement.

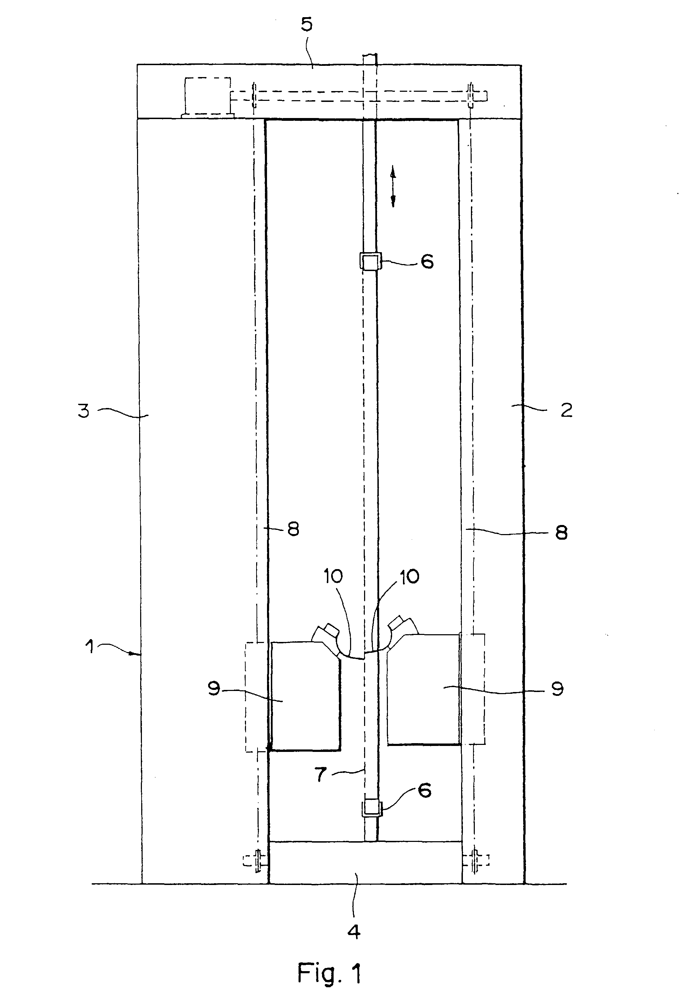

Wie aus der schematischen Darstellung gemäss Fig. 1 ersichtlich ist, besteht die Einrichtung zur Beschichtung von Drucksieben aus einem Ständerrahmen 1, der aus zwei vertikalen Säulen 2 und 3, einem Sockel 4 und die beiden Säulen 2 und 3 verbindenden oberen Querträger 5 zusammengesetzt ist. Am Sockel 4 und am Querträger 5 ist jeweils ein U-Profil 6 angebracht, in welchen ein zu beschichtendes Drucksieb 7 in bekannter Weise aufgenommen werden kann.

An den beiden Säulen 2 und 3 sind jeweils vertikal verlaufende Längsführungen 8 angebracht. Entlang dieser Längsführungen 8 ist in bekannter Weise je ein Wagen 9 vertikal verfahrbar angebracht. An jedem der Wagen 9 ist ein Rakelelement 10 angeordnet.

Zum Beschichten des Drucksiebes 7, beispielsweise mit einer Fotoemulsion, werden die mit dieser Fotoemulsion gefüllten Rakelelemente 10 an das Drucksieb 7 angestellt und in die verschwenkte Position gebracht, wie dies aus Fig. 1 ersichtlich ist, wonach die beiden Wagen 9 entlang der Längsführungen 8 von unten nach oben verfahren. Nach dem Beendigen des Beschichtens des Drucksiebs 7 werden die Rakelelemente 10 in die Ausgangslage zurückgeschwenkt und vom Drucksieb 7 abgestellt. Das nunmehr beschichtete Drucksieb 7 kann aus der Einrichtung weggenommen werden.

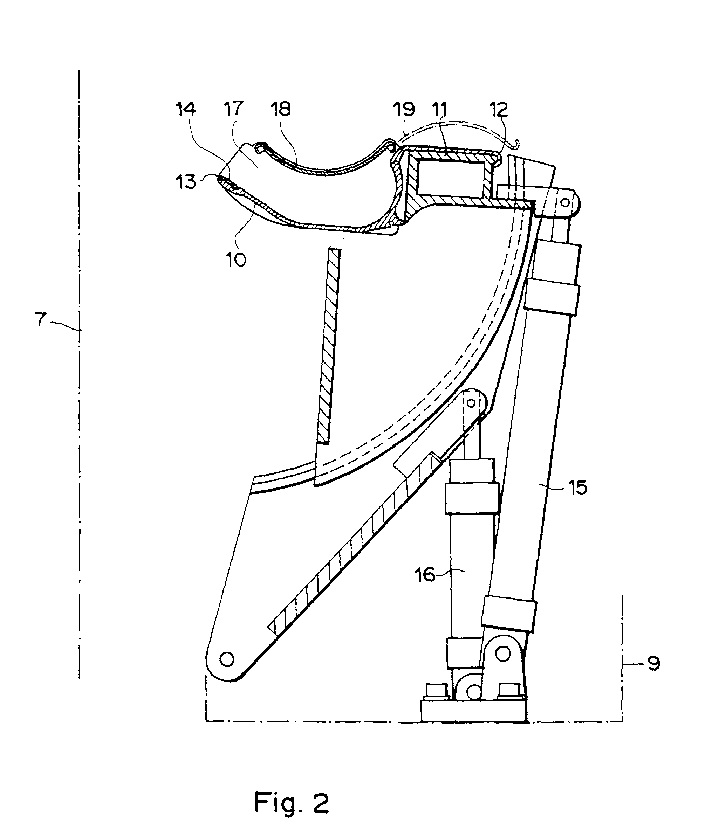

Wie aus Fig. 2 ersichtlich ist, liegt das Rakelelement 10 in Form eines Profiles vor, welches in eine Halterung 11 einsetzbar ist, die im Wagen 9 angeordnet ist. Der Wagen 9 ist hierbei nur durch strichpunktierte Linien angedeutet. Die Halterung 11 besteht im wesentlichen aus einem Vierkantprofil, in welches das Rakelelement 10, das hierzu mit einer hakenförmigen Verlängerung 12 versehen ist, einhängbar ist. Die Halterung 11 mit dem daran eingehängten Rakelelement 10 lässt sich in bekannter Weise aus der hier dargestellten Lage an das Drucksieb 7 anstellen und um eine durch die Rakelvorderkante verlaufende Schwenkachse 13 verschwenken. Die Rakelvorderkante wird hierbei durch ein Kantenelement 14 gebildet, wie nachfolgend noch beschrieben wird. Das An- und Abstellen und das Verschwenken des Rakelelementes 10 erfolgt in bekannter Weise über pneumatische Zylinder 15 und 16, die im Wagen 9 angebracht sind.

Das Rakelelement 10 ist jeweils stirnseitig mit einer Seitenwand 17 abgeschlossen, die durch Verschraubung am Rakelelement 10 befestigt sind. Der nach oben offene Bereich des eine Wanne bildenden Rakelelementes 10 kann durch eine schwenkbare Abdeckung 18 abgedeckt sein, die von einer verschlossenen Lage in eine aufgeschwenkte Lage gebracht werden kann, wie dies in Fig. 2 durch strichpunktierte Linien 19 dargestellt ist.

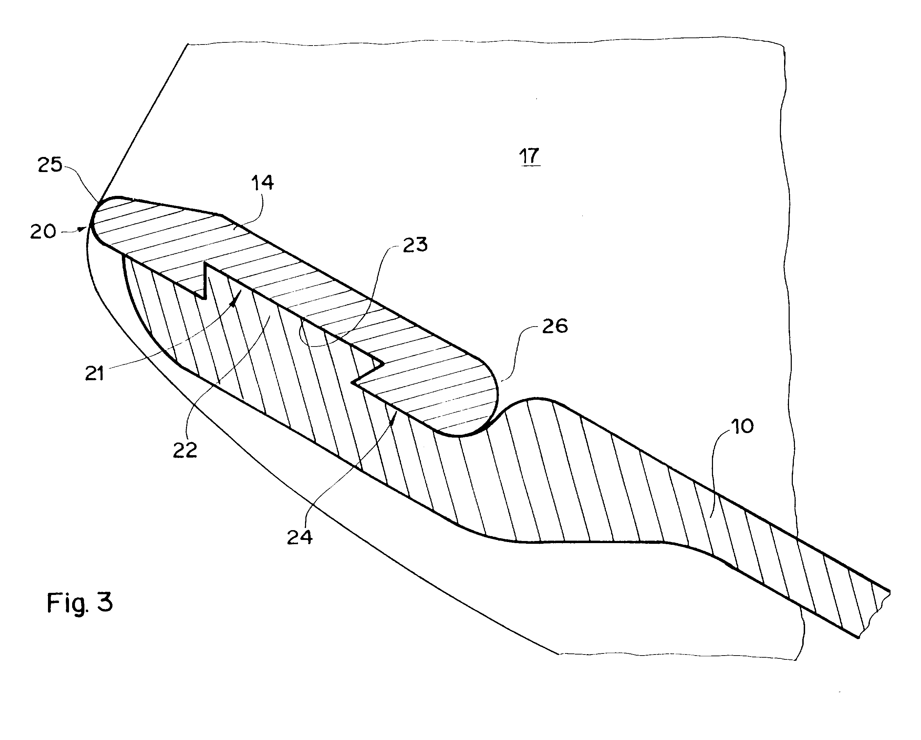

Fig. 3 zeigt im Schnitt den Bereich der Rakelvorderkante des Rakelelementes 10. Am Rakelelement 10 sind im Bereich der Rakelvorderkante 20 Haltemittel 21 angebracht, durch welche das Kantenelement 14 am Rakelelement 10 gehalten ist. Diese Haltemittel 21 bestehen in diesem Ausführungsbeispiel aus einem Schwalbenschwanzprofil 22, das am Rakelelement 10 im Bereich der Rakelvorderkante 20 angeformt ist und sich über die ganze Länge des Rakelelementes 10 erstreckt. Dieses Schwalbenschwanzprofil 22 wirkt mit einer entsprechend geformten Nut 23 zusammen, welche im Kantenelement 14 angebracht ist und sich ebenfalls über dessen gesamte Länge erstreckt. Zum Aufsetzen des Kantenelementes 14 auf dem Rakelelement 10 wird eine der beiden Seitenwände 17 weggenommen, wodurch das Kantenelement 14 mit dessen Nut 23 auf das Schwalbenschwanzprofil 22 des Rakelelementes 10 aufgeschoben werden kann. Danach kann die Seitenwand wieder befestigt werden, das Kantenelement 14 wird optimal und in genauer Lage gehalten und ist zwischen den beiden Seitenwänden 17 gegen Verschieben gesichert.

Das Schwalbenschwanzprofil 22 des Rakelelementes 10 ist in einer längs des Rakelelementes 10 verlaufenden Ausnehmung 24 angeordnet, wodurch die der Nut 23 abgewandte Oberfläche des Kantenelementes 14 und die die Wanne bildende Oberfläche des Rakelelementes 10 im aufgesetzten Zustand des Kantenelementes 14 im Bereich der Rakelvorderkante 20 im wesentlichen in einer Ebene liegen.

Das Kantenelement 14 ist im vorliegenden Ausführungsbeispiel aus einem Flachprofil gebildet, von welchem die beiden Schmalseiten 25 und 26 jeweils als Rakelkante ausgebildet sind. Diese beiden Rakelkanten können identisch sein, sie können aber auch unterschiedliche Formen haben. Mit dieser Einrichtung kann nach Verschleiss der einen Rakelkante das Kantenelement 14 vom Rakelelement 10 abgezogen, umgedreht und wieder aufgeschoben werden, so dass die noch neue unverbrauchte Rakelkante eingesetzt werden kann.

Das Kantenelement 14 kann prinzipiell aus einem beliebigen geeigneten Material hergestellt werden, so dass für die entsprechenden Anwendungen das insbesondere hinsichtlich Verschleissfestigkeit am besten geeignete Material verwendet werden kann. Des weitern kann durch Auswechseln des Kantenprofils 14 das Rakelelement 10 für andere Anwendungszwecke problemlos umgerüstet werden, beispielsweise wenn andere Schichtdicken verlangt werden, was durch einen anderen Krümmungsradius der Rakelvorderkante 20 erreicht werden kann.

Die Haltemittel 21, die im vorliegenden Ausführungsbeispiel als Schwalbenschwanzverbindung ausgeführt sind, können ohne weiteres auch anders ausgebildet sein, beispielsweise als einfache Verschraubung oder Klemmvorrichtungen.

Bevorzugterweise wird pro Rakelelement 10 nur ein Kantenelement 14 eingesetzt, so dass Stossstellen vermieden werden können, es ist aber ohne weiteres denkbar, auch mehrere Kantenelemente auf ein Rakelelement 10 aufzusetzen, welche dann eine Reihe bilden. Dies kann möglicherweise bei sehr grossen Längen eines Rakelelementes zur Anwendung kommen und von Vorteil sein.

Mit dieser erfindungsgemässen Ausgestaltung von Rakelelementen können die Einsatzmöglichkeiten durch einfachste Vorkehrungen vergrössert werden, und insbesondere wird der Anfall an Verschleissmaterial massiv reduziert.

## Patentansprüche

1. Rakelelement (10) für eine Einrichtung zum Beschichten von Drucksieben (7), wobei das Rakelelement (10) durch mindestens einen Wagen (9) gehalten ist, welcher entlang des zu beschichtenden Drucksiebes (7) verfahrbar ist, und das Rakelelement (10), das eine Wanne bildet, welche beidseitig mit Seitenwänden (17) abgeschlossen ist, an das Drucksieb (7) an- und abstellbar und um eine Schwenkachse schwenkbar ist, die durch die Rakelvorderkante (20) verläuft, dadurch gekennzeichnet, dass am Rakelelement (10) im Bereich der Rakelvorderkante (20) Haltemittel (21) angebracht sind, durch welche mindestens ein die Rakelvorderkante (20) bildendes austauschbares Kantenelement (14), das auf das Rakelelement (10) aufsetzbar ist, gehalten ist.

2. Rakelelement nach Anspruch 1, dadurch gekennzeichnet, dass das mindestens eine Kantenelement (14) aus einem Flachprofil gebildet ist, das mit einer Breitseite auf einem Bereich des Rakelelementes (10) aufliegt und durch die Haltemittel (21) gehalten ist, und dass mindestens eine der beiden Schmalseiten (25 bzw. 26) als Rakelkante ausgebildet ist.

3. Rakelelement nach Anspruch 2, dadurch gekennzeichnet, dass beide Schmalseiten (25, 26) des Kantenelementes (14) als Rakelkante ausgebildet sind.

4. Rakelelement nach einem der Ansprüche 1 bis 3, dadurch gekennzeichnet, dass im Bereich der Rakelvorderkante (20) im Rakelelement (10) eine längs des Rakelelements (10) verlaufende Ausnehmung (24) angebracht ist, in welche das Kantenelement (14) im aufgesetzten Zustand zu liegen kommt.

5. Rakelelement nach einem der Ansprüche 1 bis 4, dadurch gekennzeichnet, dass die Haltemittel (21) aus einem im Bereich der Rakelvorderkante (20) am Rakelelement (10) angebrachten, längs verlaufenden Schwalbenschwanzprofil (22) und einer am mindestens einem Kantenelement (14) angebrachten, dem Schwalbenschwanzprofil (22) entsprechenden, ebenfalls längs verlaufenden Nut (23) bestehen, und dass das Kantenelement (14) mit dieser Nut (23) auf das Schwalbenschwanzprofil (22) des Rakelelementes (10) aufschiebbar und gehalten ist.

6. Rakelelement nach einem der Ansprüche 1 bis 5, dadurch gekennzeichnet, dass das Kantenelement (14) eine Länge aufweist, die der Länge des Rakelelements (10) entspricht.

7. Rakelelement nach einem der Ansprüche 1 bis 5, dadurch gekennzeichnet, dass dieses vorzugsweise aus einem Aluminiumprofil besteht, das durch Ziehen herstellbar ist.

8. Rakelelement nach einem der Ansprüche 1 bis 7, dadurch gekennzeichnet, dass dieses durch eine schwenkbare Abdeckung (18) abgedeckt ist.

## Revendications

1. Raclette (10) pour appareil d'enduction d'écrans de sérigraphie (7), la raclette (10) étant portée par au moins un chariot (9) qui peut être déplacé le long de l'écran de sérigraphie (7) à enduire et cette raclette (10), qui forme une cuvette limitée des deux côtés par des parois latérales (17), pouvant être amenée à l'écran de sérigraphie (7) y être laissée, et pivotant autour d'un axe de pivotement qui passe dans le bord avant (20) de la raclette, caractérisée en ce que la raclette (10) est pourvue, au voisinage de son bord avant (20), de moyens de fixation (21) portant au moins un élément à bord (14), pouvant être remplacé, qui forme le bord avant (20) de la raclette et pouvant être monté sur la raclette (10) .

2. Raclette selon la première revendication, caractérisée en ce que l'élément à bord (14), dont il existe au moins un exemplaire, est constitué par un profilé plat qui repose, par un côté large, sur une partie de la raclette (10) et qui est maintenu par les moyens de fixation (21), et en ce qu'au moins l'un des côtés étroits (25 et 26) est réalisé sous la forme d'une arête de raclage.

3. Raclette selon la revendication 2, caractérisée en ce que les deux côtés étroits (25, 26) de l'élément à bord (14) sont réalisés sous la forme d'arêtes de raclage.

4. Raclette selon l'une des revendications 1 à 3, caractérisée en ce que, au voisinage du bord avant (20) de la raclette, il y a dans la raclette (10) une échancrure longitudinale (24) dans laquelle vient se placer l'élément à bord (14) quand on l'a mis en place.

5. Raclette selon l'une des revendications 1 à 4, caractérisée en ce que les moyens de fixation (21) sont constitués par un profilé en queue-d'aronde (22) placé sur la raclette (10) près du bord avant (20) et par une rainure (23), également longitudinale, pratiquée dans l'élément à bord (14) ou les éléments à bord (14) et correspondant au profilé en queue-d'aronde (22), et en ce que, avec cette rainure (23), l'élément à bord (14) peut être glissé sur le profilé en queue-d'aronde (22) de la raclette (10) et y est maintenu.

6. Raclette selon l'une des revendications 1 à 5, caractérisée en ce que la longueur de l'élément à bord (14) correspond à la longueur de la raclette (10).

7. Raclette selon l'une des revendications 1 à 5, caractérisée en ce qu'elle est constituée de préférence par un profilé d'aluminium pouvant être fabriqué par étirage.

8. Raclette selon l'une des revendications 1 à 7, caractérisée en ce qu'elle est pourvue d'un recouvrement pivotant (18).

## Claims

1. Doctor blade element (10) for a device for coating printing screens (7), the doctor blade element (10) being held by at least one carriage (9), which is drivable along the printing screen (7) to be coated, and the doctor blade element (10), which forms a trough which is closed off by side walls (17) on both sides, being able to be placed on and taken off, and being pivotable about a pivot axis which runs through the doctor blade leading edge (20), characterised in that provided on the doctor blade element (10) in the region of the doctor blade leading edge (20) are holding means (21) by means of which at least one exchangeable edge element (14) forming the doctor blade leading edge (20) can be put on the doctor blade element (10).

2. Doctor blade element according to claim 1, characterised in that the at least one edge element (14) is made up of a flat section, which lies, with a wide face, on a region of the doctor blade element (10), and is held by the holding means (21), and in that at least one of the two narrow faces (25, respectively 26) is designed as the doctor blade edge.

3. Doctor blade element according to claim 2, characterised in that both narrow faces (25, 26) of the edge element (14) are designed as the doctor blade edge.

4. Doctor blade element according to one of the claims 1 to 3, characterised in that in the doctor blade element (10) in the region of the doctor blade leading edge (20) a recess (24) is provided running along the doctor blade element (10), in which recess the edge element (14) comes to lie in the placed-on state.

5. Doctor blade element according to one of the claims 1 to 4, characterised in that the holding means (21) consist of a longitudinally running dovetail section (22), provided on the doctor blade element (10) in the region of the doctor blade leading edge (20) and of a likewise longitudinally running groove (23), corresponding to the dovetail section (22), provided on at least one edge element (14), and in that the edge element (14) with this groove (23) can be slid and is held on the dovetail section (22) of the doctor blade element (10).

6. Doctor blade element according to one of the claims 1 to 5, characterised in that the edge element (14) has a length which corresponds to the length of the doctor blade element (10).

7. Doctor blade element according to one of the claims 1 to 5, characterised in that it preferably consists of an aluminium section which can be produced by drawing.

8. Doctor blade element according to one of the claims 1 to 7, characterised in that it is covered by a pivotable covering (18).
